# EUROPEAN PATENT APPLICATION

(11) **EP 4 637 030 A1**
(43) Date of publication of application: **22.10.2025**
(21) Application number: 23903443.2
(22) Date of filing: 08.12.2023
(51) Int. Cl.: H03F 3/34, G05F 1/613, H04R 3/00

(54) **CONVERSION CIRCUIT AND ELECTRONIC CIRCUIT**

(30) Priority: 15.12.2022 JP 2022200327
(71) Applicant: University of Tsukuba, Ibaraki 305-8577 (JP)
(72) Inventor: OBO, Hirotaka, Tsukuba-shi, Ibaraki 305-8577 (JP); EBIHARA, Tadashi, Tsukuba-shi, Ibaraki 305-8577 (JP); MIZUTANI, Koichi, Tsukuba-shi, Ibaraki 305-8577 (JP); WAKATSUKI, Naoto, Tsukuba-shi, Ibaraki 305-8577 (JP)
(74) Representative: Bryn Aarflot AS
(86) International application number: PCT/JP2023/044030
(87) International publication number: WO 2024/128156

(57) **Abstract**

A conversion circuit is a conversion circuit that converts an input current into an output voltage, the conversion circuit including a first terminal that is an input unit for the input current; a second terminal that is ground, a third terminal that is an output unit for an output voltage, the third terminal being configured to supply a power supply voltage via a power supply resistor, a first resistor, one end of which is connected to the first terminal and the other end of which is connected to the third terminal, and a regulator configured to detect a difference between a voltage at the first terminal and a predetermined reference voltage, and, when the voltage at the first terminal is higher than the reference voltage, perform control of adjusting an amount of current flowing from the third terminal to the second terminal according to a magnitude of the difference, lowering a voltage of the third terminal, and maintaining the voltage at the first terminal at the reference voltage, in which a gain of the conversion circuit is determined by the first resistor.

## Description

### [Technical Field]

The present invention relates to a conversion circuit and an electronic circuit.

### [Background Art]

Examples of circuits and elements that are powered include a capacitor microphone unit and a sensor. For example, in the case of a capacitor microphone, it is generally integrated with a field effect transistor (FET), or a FET is used externally. Therefore, when using a capacitor microphone, it is necessary to supply a power supply voltage to the FET.

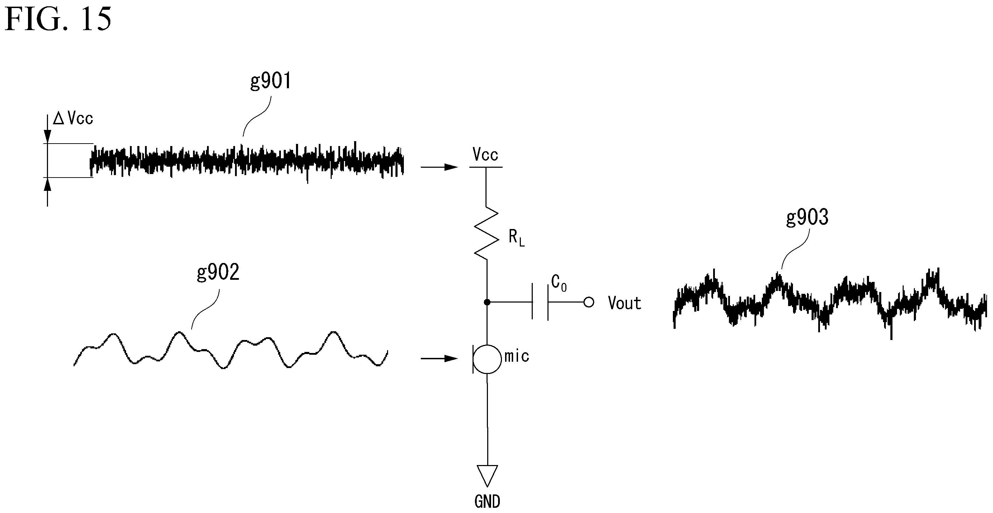

FIG. 15 is a view illustrating a microphone circuit and an input/output signal example of a known technique. If the microphone mic is a capacitor microphone, a power supply voltage Vcc is supplied via a resistor R_{L} as shown in FIG. 15. Note that the microphone mic includes the FET. Then, an incoming signal (reference sign g902) collected by the microphone mic is output via a capacitor Co. Note that if the fluctuation of the current flowing through the microphone mic be ΔImic and the fluctuation of the power supply voltage Vcc due to noise be ΔVcc, the voltage fluctuation ΔVout of the output signal from the output terminal Vout is expressed as ΔVcc - R_{L} × ΔImic. If the power supply has noise (reference sign g901), since ΔVout includes a term of ΔVcc, power supply noise is superimposed on the output signal (reference sign g903).

As a measure against noise superimposed on the output of such a capacitor microphone, a configuration has been proposed in which a noise component superimposed on the power supply voltage Vcc is applied to the non-inverting input terminal of an operational amplifier by capacitive coupling with an internal power supply line using the operational amplifier, thereby canceling the noise component at the operational amplifier (see, for example, Patent Document 1).

The fundamental reason for proposing a circuit configuration that cancels such a noise component is not only that power supply noise is easily superimposed on a signal but also the fact that a sensor and an electronic circuit (e.g., an amplifier circuit) are easily installed apart from each other. For example, if an amplifier circuit is installed in the vicinity of a sensor, a stable power supply for the amplifier circuit may be required, separate from the weak-voltage application for the sensor. As a result, the sensor and the electronic circuit are installed apart from each other, and external noise, such as power supply noise and transmission line noise are superimposed on the signal.

### [Citation List]

### [Patent Literature]

[PTL 1]
JP 2010-245729 A

### [Summary of Invention]

### [Technical Problem]

However, the technique described in Patent Document 1 required many external circuit components for a microphone or a microphone unit. The circuit described in Patent Document 1 is a circuit dedicated to a capacitor microphone, and it was difficult to apply it to other elements, for example, sensors.

The present invention has been made in view of the above problems, and an object of the present invention is to provide a conversion circuit and an electronic circuit that can reduce the superimposition of noise.

### [Solution to Problem]

(1) In order to achieve the object described above, a conversion circuit according to one aspect of the present invention is a conversion circuit that converts an input current into an output voltage, the conversion circuit including: a first terminal that is an input unit for the input current; a second terminal that is ground; a third terminal that is a power supply unit for the conversion circuit and is an output unit for an output voltage; a first resistor, one end of which is connected to the first terminal and the other end of which is connected to the third terminal; and a regulator configured to detect a difference between a voltage at the first terminal and a predetermined reference voltage, and, when the voltage at the first terminal is higher than the reference voltage, perform control of adjusting an amount of current flowing from the third terminal to the second terminal according to a magnitude of the difference, and maintaining the voltage at the first terminal at the reference voltage, in which a gain of the conversion circuit is determined by the first resistor.
(2) In the conversion circuit (1) described above, the current flowing from the third terminal to the second terminal may be a sink current, and the sink current may be supplied to the third terminal from an outside of the conversion circuit.
(3) In the circuit of (1) or (2) described above, the regulator may include a variable shunt regulator, a reference terminal of the variable shunt regulator may be connected to the first terminal, an anode terminal of the variable shunt regulator may be connected to the second terminal, and a cathode terminal of the variable shunt regulator may be connected to the third terminal.
(4) In the conversion circuit of (1) or (2) described above, the regulator may include an operational amplifier and an NPN type first transistor, a positive input terminal of the operational amplifier may be connected to the first terminal, the reference voltage may be input to a negative input terminal of the operational amplifier, an output terminal of the operational amplifier may be connected to a base of the first transistor, a collector of the first transistor may be connected to the third terminal, and an emitter of the first transistor may be connected to the second terminal.
(5) In the conversion circuit of (1) or (2) described above, the regulator may include an NPN type first transistor, an NPN type second transistor, and a second resistor, a base of the first transistor may be connected to the first terminal, the emitter of the first transistor may be connected to the second terminal via the second resistor, an emitter of the first transistor may be connected to a base of the second transistor, a collector of the first transistor may be connected to a collector of the second transistor, a collector of the second transistor may be connected to the third terminal, and an emitter of the second transistor may be connected to the second terminal.
(6) In the conversion circuit of (1) or (2) described above, the regulator may include an NPN type first transistor, an NPN type second transistor, a PNP type third transistor, an NPN type fourth transistor, a second resistor, a third resistor, and a fourth resistor, a base of the first transistor may be connected to the first terminal, an emitter of the first transistor may be connected to the second terminal via the second resistor, the emitter of the first transistor may be connected to a base of the second transistor, a collector of the first transistor may be connected to the third terminal, an emitter of the second transistor may be connected to the second terminal, a collector of the second transistor may be connected to the third terminal via the third resistor, the collector of the second transistor may be connected to a base of the third transistor, an emitter of the third transistor may be connected to the third terminal, a collector of the third transistor may be connected to a base of the fourth transistor, the collector of the third transistor may be connected to the second terminal via the fourth resistor, a collector of the fourth transistor may be connected to the third terminal, and an emitter of the fourth transistor may be connected to the second terminal.
(7) In the conversion circuit of (1) or (2) described above, the regulator may include an NPN type first transistor, an NPN type second transistor, a PNP type third transistor, a second resistor, and a third resistor, a base of the first transistor may be connected to the first terminal, an emitter of the first transistor may be connected to the second terminal via the second resistor, the emitter of the first transistor may be connected to a base of the second transistor, a collector of the first transistor may be connected to the third terminal, an emitter of the second transistor may be connected to the second terminal, a collector of the second transistor may be connected to the third terminal via the third resistor, the collector of the second transistor may be connected to a base of the third transistor, an emitter of the third transistor may be connected to the third terminal, and a collector of the third transistor may be connected to the second terminal.
(8) In the conversion circuit of (1) or (2) described above, the regulator may include a first field effect transistor, a second field effect transistor, and a second resistor, a gate of the first field effect transistor may be connected to the first terminal, a source of the first field effect transistor may be connected to the second terminal via the second resistor, a source of the first field effect transistor may be connected to a gate of the second field effect transistor, a drain of the first field effect transistor may be connected to a drain of the second field effect transistor, a drain of the second field effect transistor may be connected to the third terminal, and a source of the second field effect transistor may be connected to the second terminal.
(9) In the conversion circuit of (1) or (2) described above, the regulator may include an operational amplifier and a diode, a positive input terminal of the operational amplifier may be connected to the first terminal, the reference voltage may be input to a negative input terminal of the operational amplifier, an output terminal of the operational amplifier may be connected to an anode of the diode, and a cathode of the diode may be connected to the second terminal.
(10) In the conversion circuit of (9) described above, a positive power supply terminal of the operational amplifier may be connected to the third terminal, and a negative power supply terminal of the operational amplifier may be connected to the second terminal.
(11) In the conversion circuit of at least one of (1) to (10) described above, output impedance of the conversion circuit may be 1 Ω or less.
(12) The conversion circuit of at least one of (1) to (11) described above may include at least one of a power supply resistor, one end of which is connected to the third terminal and the other end of which is connected to a power supply voltage, a capacitor, one end of which is connected to the third terminal and the other end of which serves as an output end to a load side, or a capacitor, one end of which is connected to the third terminal and the other end of which is connected to the first terminal.
(13) In order to achieve the object described above, an electronic circuit according to one aspect of the present invention is an electronic circuit including the conversion circuit of at least one of (1) to (12) described above and including a sensor connected to the input unit.
(14) In the electronic circuit of (13) described above, the sensor may be one of a capacitor microphone, a piezoelectric sensor, a pressure sensor, an acceleration sensor, an optical sensor, and a crystal oscillator.

### [Advantageous Effects of Invention]

According to (1) to (14), noise superposition can be reduced.

### [Brief Description of Drawings]

FIG. 1 is a view illustrating a capacitor microphone, a power supply circuit, and an equivalent circuit at an operating point of a capacitor microphone unit.
FIG. 2 is a view illustrating an electronic circuit example of a first example.
FIG. 3 is a view illustrating an electronic circuit example of a second example.
FIG. 4 is a view illustrating a modification of the second example.
FIG. 5 is a view illustrating a signal waveform example when a sound signal is collected using a microphone unit.
FIG. 6 is a view illustrating a result example of actually measuring a power supply voltage fluctuation rejection ratio.
FIG. 7 is a result example of actually measuring a relationship between a power supply voltage Vcc in the electronic circuit and an output voltage output from an output terminal Vout.
FIG. 8 is a view illustrating a configuration example of an electronic circuit of a third example.
FIG. 9 is a view illustrating a relationship between a power supply voltage Vcc and an output voltage output from an output terminal Vout in the third example.
FIG. 10 is a view illustrating a configuration example of an electronic circuit of a fourth example.
FIG. 11 is a view illustrating a relationship between a power supply voltage Vcc and an output voltage output from an output terminal Vout in the fourth example.
FIG. 12 is a view illustrating a configuration example of an electronic circuit of a fifth example.
FIG. 13 is a view illustrating a relationship between a power supply voltage Vcc and an output voltage output from an output terminal Vout in the fifth example.
FIG. 14 is a view illustrating a configuration example of an electronic circuit in a case where a sensor is a crystal oscillator.
FIG. 15 is a view illustrating a microphone circuit and an input/output signal example of the known technique.
FIG. 16 is a view illustrating a configuration example of an electronic circuit of a sixth example.
FIG. 17 is a view illustrating a configuration example of an electronic circuit of a seventh example.

### [Description of Embodiments]

Embodiments of the present invention will be described below with reference to the drawings. Note that in the drawings used in the following description, the scale of each member is appropriately changed, to make each member recognizable.

Note that in all the drawings for describing the examples, those having identical functions are denoted by identical reference signs, and repeated description will be omitted.

As used herein, "based on XX" means "based on at least XX," and includes a case of being based on another element in addition to XX. Also, "based on XX" is not limited to a case where XX is directly used, and includes a case based on calculation or processing performed on XX. "XX" is any element (e.g., optional information).

First, a general circuit in a case of using a capacitor microphone and an equivalent circuit at an operating point of a capacitor microphone unit will be described.

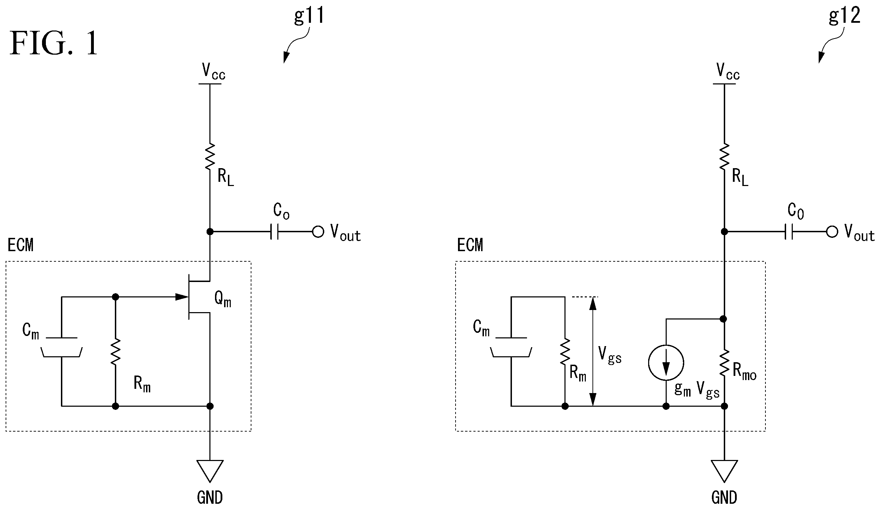

FIG. 1 is a view illustrating the capacitor microphone, a power supply circuit, and an equivalent circuit at an operating point of the capacitor microphone unit.

The view of reference sign g11 is an example of the capacitor microphone and the power supply circuit. As illustrated by reference sign g11, a capacitor microphone unit ECM includes, for example, a capacitor microphone Cₘ, a resistor Rₘ, and an FETQₘ. The capacitor microphone Cₘ has one end connected to one end of the resistor Rₘ and the gate of the FETQₘ, and has the other end connected to ground (GND). The other end of the resistor Rₘ is connected to ground. The FETQₘ has a drain connected to one end of a resistor R_{L} and one end of a capacitor Co, and has a source connected to ground. The other end of the resistor R_{L} is connected to the power supply voltage Vcc. The other end of the capacitor Co is connected to the output terminal Vₒᵤₜ.

The resistor Rₘ is an input bias resistor for the FETQₘ. The FETQₘ has a role of impedance conversion. The resistor R_{L} is a load resistor that supplies the power supply voltage Vcc to the FETQₘ. The capacitor Co is a capacitor for cutting off an alternating-current component.

The view of reference sign g12 is an equivalent circuit at an operating point of the capacitor microphone unit ECM. The equivalent circuit at the operating point of the capacitor microphone unit ECM can be represented by the capacitor microphone Cₘ, the resistor Rₘ, a current source gₘ, and a fixed resistor R_{mO}.

As described with reference to FIG. 1, the equivalent circuit of the capacitor microphone unit ECM can be regarded as a current source. Therefore, a circuit configuration may exclude power supply noise ΔVcc in an output term, and thus the power supply noise ΔVcc included in the power supply voltage Vcc is reduced.

### (First Example)

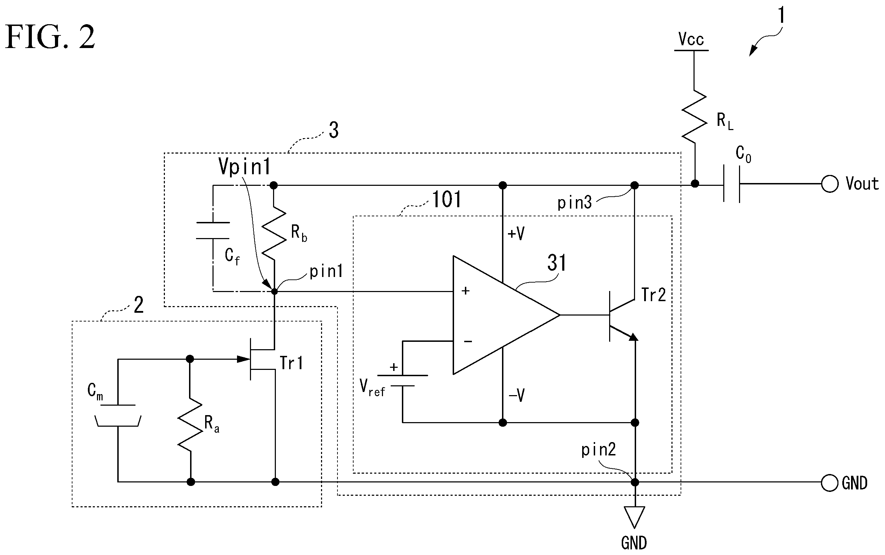

FIG. 2 is a view illustrating an electronic circuit example of the first example. As in FIG. 2, an electronic circuit 1 includes a sensor 2 and a conversion circuit 3. Note that in the description of each of the following examples, a microphone unit is used as an example of the sensor 2, but the sensor 2 is not limited to being a microphone unit and may be, for example, a piezoelectric sensor or the like as described later.

The sensor 2 is, for example, the capacitor microphone unit ECM. The sensor 2 includes, for example, the capacitor microphone Cₘ, the resistor Rₐ, and a field effect transistor Tr1.

The conversion circuit 3 includes, for example, a capacitor Cr, a resistor R_{b} (first resistor), a reference power supply V_{ref}, an operational amplifier 31, and a transistor Tr2 (first transistor). Note that the conversion circuit 3 may include the resistor R_{L} (power supply resistor) and the capacitor C_{O}.

The regulator 101 includes, for example, the operational amplifier 31, the transistor Tr2 (first transistor), and the reference power supply V_{ref}. The conversion circuit 3 need not include the capacitor C_{f} for preventing oscillation.

Next, a connection configuration of the conversion circuit 3 will be described.

The capacitor C_{f} has one end connected to one end of the resistor R_{b}, one end of the resistor R_{L}, one end of the capacitor C_{O}, and a collector of the transistor Tr2, and has the other end connected to the other end of the resistor R_{b}, a positive input terminal (+) of the operational amplifier 31, and an output of the sensor 2.

The operational amplifier 31 has a negative input terminal (-) connected to a positive electrode of the reference power supply V_{rcf}, and has an output terminal connected to a base of the transistor Tr2. Note that a positive power supply terminal +V of the operational amplifier 31 is connected to one end of the resistor R_{L}, a negative power supply terminal -V is connected to ground, and an emitter of the transistor Tr2 is connected to ground.

A negative electrode of the reference power supply V_{ref} is connected to ground. Note that the reference power supply V_{rcf} may be, for example, a Zener diode circuit. In this case, for example, another first resistor not illustrated may have one end connected to one end of the resistor R_{L}, the other first resistor may have the other end connected to a cathode of another first Zener diode not illustrated and the negative input terminal of the operational amplifier 31, and an anode of the other first Zener diode may be connected to ground.

The other end of the resistor R_{L} is connected to the power supply voltage Vcc.

The other end of the capacitor C_{O} is connected to the output terminal Vout.

Next, in the conversion circuit 3, a first terminal, a second terminal, and a third terminal are defined.

In the conversion circuit 3, an intersection of an output terminal of the sensor 2 (drain of the field effect transistor Tr1), the other end of the resistor R_{b}, the other end of the capacitor C_{f}, and the positive input terminal of the operational amplifier 31 is a first terminal pin1. In this manner, the first terminal pin1 is an input unit of the conversion circuit 3. Let the voltage at the first terminal pin1 be Vpin1.

Let an intersection of the emitter of the transistor Tr2 and the negative electrode of the reference power supply V_{ref} be a second terminal pin2. Note that the second terminal pin2 is ground. The negative power supply terminal -V of the operational amplifier 31 is connected to the second terminal pin2.

Let an intersection of one end of the resistor R_{b}, one end of the capacitor C_{f}, the collector of the transistor Tr2, one end of the resistor R_{L}, and one end of the capacitor Co be a third terminal pin3. In this manner, the third terminal pin3 is a power supply unit as well as an output unit of the conversion circuit 3. The positive power supply terminal +V of the operational amplifier 31 is connected to the third terminal pin3.

Note that the positive power supply terminal +V and the negative power supply terminal -V of the operational amplifier 31 may be connected to another external power supply not illustrated without being connected to the third terminal pin3 and the second terminal pin2.

In the conversion circuit 3, a gain (R_{b}Is/Is) is determined by the resistor R_{b}. Note that the current Is is the signal current from the capacitor microphone unit ECM. In the conversion circuit 3, the operational amplifier 31 is, for example, an operational amplifier, and has a role of an error circuit that detects an error between a signal input to the positive input terminal and a voltage at the reference power supply. The signal current from the capacitor microphone unit ECM is converted into a voltage by the conversion circuit 3. The regulator 101 controls the output voltage. Note that the regulator 101 controls the output voltage using a sink current.

That is, the regulator 101 detects a difference between the voltage at the first terminal and a predetermined reference voltage, and, when the voltage at the first terminal is higher than the reference voltage, performs control of adjusting the amount of current flowing from the third terminal to the second terminal according to the magnitude of the difference to a possible value within a specification range of the power supply voltage/current, lowering the voltage of the third terminal, and maintaining the voltage at the first terminal at the reference voltage. The current flowing from the third terminal to the second terminal is a sink current (current sink).

On the other hand, when the voltage at the first terminal is lower than the reference voltage, the sink current is adjusted, the voltage of the third terminal is increased to a possible value within a specification range of the power supply voltage/current, and the voltage at the first terminal is maintained at the reference voltage.

When the voltage at the first terminal is equal to the reference voltage, the current amount of the sink current is maintained, and the voltage at the first terminal and the reference voltage are also maintained in an equal state.

In this manner, the voltage Vpin1 at the first terminal is adjusted to be equal to the reference power supply V_{ref} by a feedback circuit described above, and the capacitor microphone unit ECM is applied with a voltage for a sensor.

Let the signal current from the capacitor microphone unit ECM, which is a sensor, be Iₛ, when it is possible to approximate that Iₛ sourced from the first terminal pin1 all flows to the resistor R_{b}, and it is possible to approximate that the voltage Vpin1 at the first terminal is equal to the reference power supply V_{rcf} by the feedback circuit described above, the output voltage is a voltage indicated by V_{rcf} + Iₛ × R_{b}.

As described above, according to the configuration of the present example, the feedback circuit works sufficiently, whereby output impedance at the third terminal can be reduced and robustness to external noise is achieved.

Furthermore, since the output unit of the conversion circuit does not have a current source structure but has a current sink structure, in the present example, the power supply unit and the output unit of the conversion circuit can be an identical terminal, which contributes to operation with a weak voltage application for the sensor.

These are also common to the conversion circuits (3A, 3B, 3C, 3D, 3E, and 3F) described later.

Since the output of the conversion circuit 3 does not include the power supply noise ΔVcc in the output term, the conversion circuit 3 of the present example has a circuit configuration robust to external noise.

By this, according to the present example, it is possible to reduce power supply noise superimposed on the output of the microphone. Then, according to the present example, since noise can be reduced, it is possible to perform recording and reproduction even of a signal having a lower level than that in the known technique without being buried in noise.

### (Second Example)

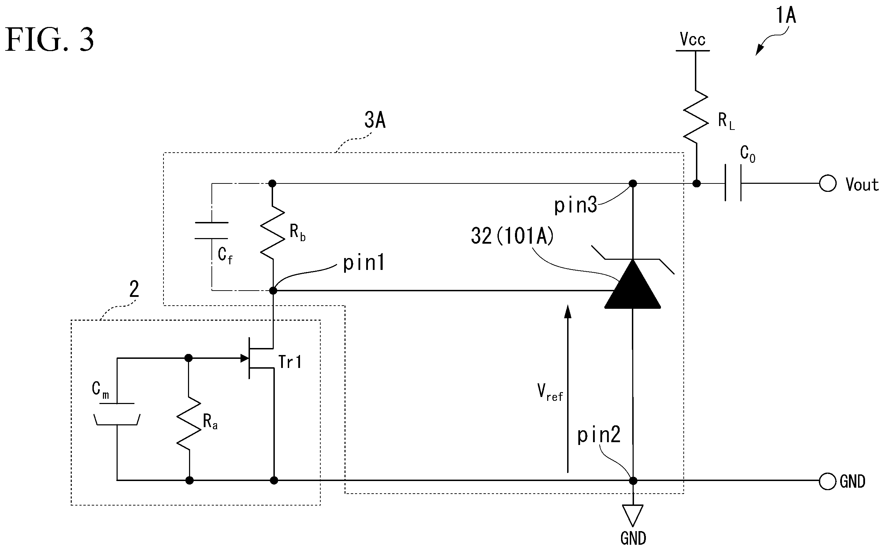

FIG. 3 is a view illustrating an electronic circuit example of the second example. As in FIG. 3, an electronic circuit 1A includes the sensor 2 and the conversion circuit 3A.

The sensor 2 is, for example, the capacitor microphone unit ECM. The sensor 2 includes, for example, the capacitor microphone Cₘ, the resistor Rₐ, and the field effect transistor Tr1.

The conversion circuit 3A includes, for example, the capacitor C_{f}, the resistor R_{b} (first resistor), and a variable shunt regulator 32. Note that the conversion circuit 3A may include the resistor R_{L} (power supply resistor) and the capacitor C_{O}.

In the conversion circuit 3A, the regulator 101A is the variable shunt regulator 32. The conversion circuit 3A need not include the capacitor C_{f} for preventing oscillation.

Next, a connection configuration of the conversion circuit 3A will be described.

The capacitor C_{f} has one end connected to one end of the resistor R_{b}, one end of the resistor R_{L}, one end of the capacitor C_{O}, and a cathode of the variable shunt regulator 32, and has the other end connected to the other end of the resistor R_{b}, a reference terminal of the variable shunt regulator 32, and the output of the sensor 2 (drain of the field effect transistor Tr1).

An anode of the variable shunt regulator 32 is connected to ground.

The other end of the resistor R_{L} is connected to the power supply voltage Vcc.

The other end of the capacitor C_{O} is connected to the output terminal Vout.

Next, in the conversion circuit 3A, the first terminal, the second terminal, and the third terminal are defined.

In the conversion circuit 3A, an intersection of the output terminal of the sensor 2 (drain of the field effect transistor Tr1), the other end of the resistor R_{b}, the other end of the capacitor C_{f}, and the reference terminal of the variable shunt regulator 32 is the first terminal pin1. In this manner, the first terminal pin1 is an input unit of the conversion circuit 3A. Let the voltage at the first terminal pin1 be Vpin1.

Let the anode of the variable shunt regulator 32 be the second terminal pin2. Note that the second terminal pin2 is ground.

Let an intersection of one end of the resistor R_{b}, one end of the capacitor Cr, the cathode of the variable shunt regulator 32, one end of the resistor R_{L}, and one end of the capacitor Co be the third terminal pin3. In this manner, the third terminal pin3 is a power supply unit as well as an output unit of the conversion circuit 3A.

In the conversion circuit 3A, the gain (R_{b}Is/Is) is determined by the resistor R_{b}. The regulator 101A (variable shunt regulator 32) controls the output voltage. Note that the regulator 101A controls the output voltage using a sink current.

Note that in this configuration, the reference voltage V_{ref} is a voltage between the reference terminal of the variable shunt regulator 32 and the second terminal pin2.

The regulator 101A (variable shunt regulator 32) detects a difference between the voltage at the first terminal and a predetermined reference voltage, and, when the voltage at the first terminal is higher than the reference voltage, performs control of adjusting the amount of current flowing from the third terminal to the second terminal according to the magnitude of the difference to a possible value within a specification range of the power supply voltage/current, lowering the voltage of the third terminal, and maintaining the voltage at the first terminal at the reference voltage. The current flowing from the third terminal to the second terminal is a sink current (current sink). Note that when the voltage at the first terminal is lower than the reference voltage or equal to the reference voltage, an operation similar to that in the first example is performed.

In the configuration of FIG. 3, the equivalent circuit of the variable shunt regulator 32 can be represented by the operational amplifier 31, the reference power supply V_{ref}, and the transistor Tr2 of the first example. That is, according to the present example, the conversion circuit 3 of the first example is achieved by using the variable shunt regulator 32, whereby the reference power supply V_{ref} is unnecessary, the power supply to the operational amplifier 31 is also unnecessary, and the circuit configuration can be further simplified. That is, in the configuration of the second example, the equivalent circuit of the variable shunt regulator 32 can be represented by the equivalent circuit of the configuration of FIG. 2.

By this, according to the present example, it is possible to reduce power supply noise superimposed on the output of the microphone. Then, according to the present example, since noise can be reduced, it is possible to perform recording and reproduction even a signal having a lower level than that in the known technique without being buried in noise.

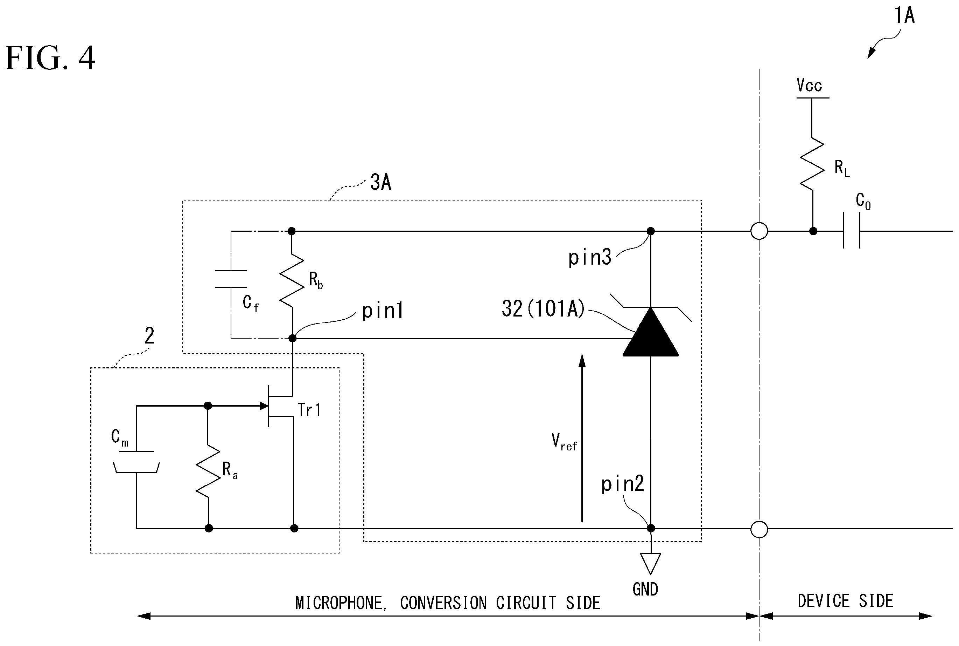

FIG. 4 is a view illustrating a modification of the second example.

FIG. 4 illustrates a configuration example in which the device side includes the resistor R_{L} and the capacitor Co. The device is a device to which outputs of the sensor 2 and the conversion circuit 3A are input, and is, for example, a recording apparatus, an IC recorder, or the like. The configuration in which power is supplied to the microphone on the device side in this manner is called, for example, a "plug-in power system". The conversion circuit 3A operates even with application of a voltage weak against such external noise for a sensor (microphone) or the like, and, unlike the known technique, can be arranged also in the vicinity of the sensor in which preparation for a stable power supply may be difficult. Note that the conversion circuit 3 described above and the conversion circuits 3B, 3C, and 3D described later may also have a configuration in which power is supplied to the microphone on the device side as in the configuration in FIG. 4.

In a case where the device is, for example, an IC recorder or the like, there is also a digital circuit inside the device, and thus, there is a case where the power supply has digital noise or the like. As described in the known technique with reference to FIG. 15, in the case where the sensor 2 is directly connected to the device, the influence of such power supply noise is large.

In the circuit configurations of FIGS. 3 and 4, the output impedance can be made much lower than that of the capacitor microphone unit ECM. For example, the actual measurement value of the output impedance in a direct-current component was 0.42 Ω in the case of using the conversion circuit 3A while 2.6 kΩ in the capacitor microphone unit ECM. The actual measurement value of the output impedance in the alternate-current component of 1 kHz was 0.37 Ω in the case of using the conversion circuit 3A while 1.9 kΩ in the capacitor microphone unit ECM. In this manner, according to the circuit configuration of the present example, since the output impedance can be reduced, a configuration robust to external noise including power supply noise and transmission line noise can be achieved. Note that the actual measurement value described above is an example, but no such limitation is intended.

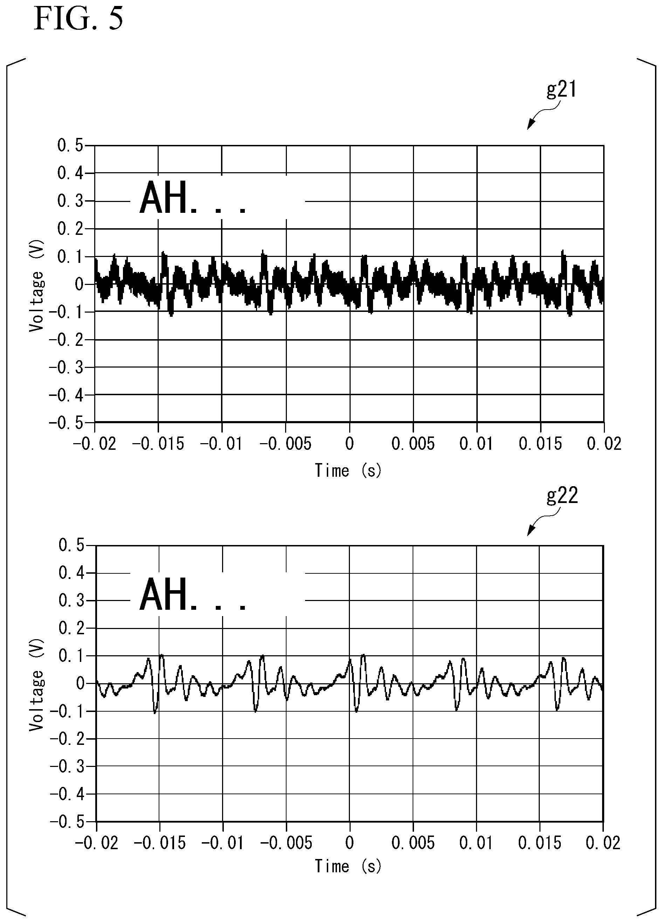

FIG. 5 is a view illustrating a signal waveform example when a sound signal is collected using the microphone unit. Note that confirmation is performed by collecting a sound signal of an utterance "Ah..." toward the capacitor microphone. A waveform of reference sign g21 is an output signal waveform in a case where the resistor R_{L} and the capacitor Co are connected to the capacitor microphone unit ECM, and noise of 100mVₚ₋ₚ is superimposed on the power supply (Vcc) supplied via the resistor R_{L}. A waveform of reference sign g22 is an output signal waveform in a case where the conversion circuit 3A is connected to the capacitor microphone unit ECM, the resistor R_{L} and the capacitor Co are connected, and noise of 100m Vₚ₋ₚ is superimposed on the power supply supplied via the resistor R_{L}. In FIG. 5, the horizontal axis represents time (seconds), and the vertical axis represents an output voltage (V). Note that the measurement conditions are Vcc of 2.7 V and R_{L} of 2.2 kΩ.

As in FIG. 5, as a result of using the conversion circuit 3A of the present example, the influence on the output signal can be reduced also in the case where the power supply noise is superimposed.

Next, a result example of actually measuring a power supply voltage fluctuation rejection ratio which is to quantitatively evaluate a power supply noise rejection effect qualitatively indicated in FIG. 5 will be described.

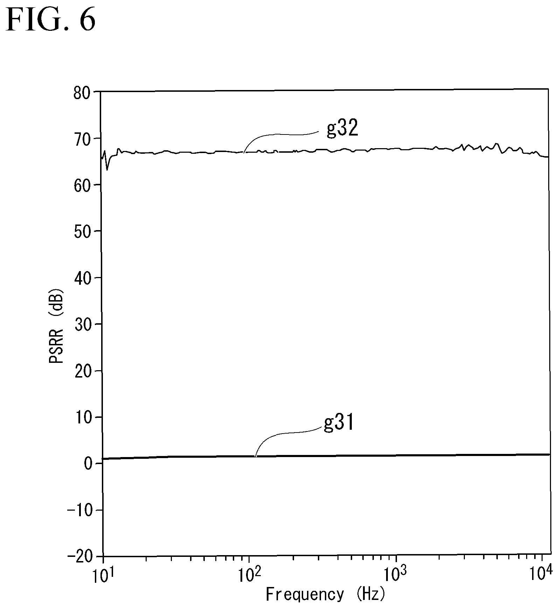

FIG. 6 is a view illustrating a result example of actually measuring the power supply voltage fluctuation rejection ratio. The horizontal axis represents a frequency (Hz), and the vertical axis represents a power supply voltage fluctuation rejection ratio (PSRR) (dB). A line g31 is the PSRR of the capacitor microphone unit ECM not including the conversion circuit 3A. When the conversion circuit 3A is not included, the PSRR is about 1.3 dB, and it can be seen that as described with reference to FIG. 1, the power supply noise ΔVcc included in the power supply voltage Vcc is not substantially attenuated and is superimposed on ΔVout as it is. On the other hand, a line g32 is the PSRR in a case where the conversion circuit 3A is used. When the conversion circuit 3A is included, the PSRR is 67 dB, and it can be seen that the power supply noise ΔVcc can be significantly rejected as compared with the case where the conversion circuit 3A is not included. Note that the measurement value given in FIG. 6 is an example, but no such limitation is intended.

In this manner, use of the conversion circuit 3A of the present example can improve the PSRR by 65 dB or more, that is, can reduce the amplitude of the power supply noise to about 1/1000.

Next, the relationship between the power supply voltage Vcc in the electronic circuit and the output voltage output from the output terminal Vout will be described.

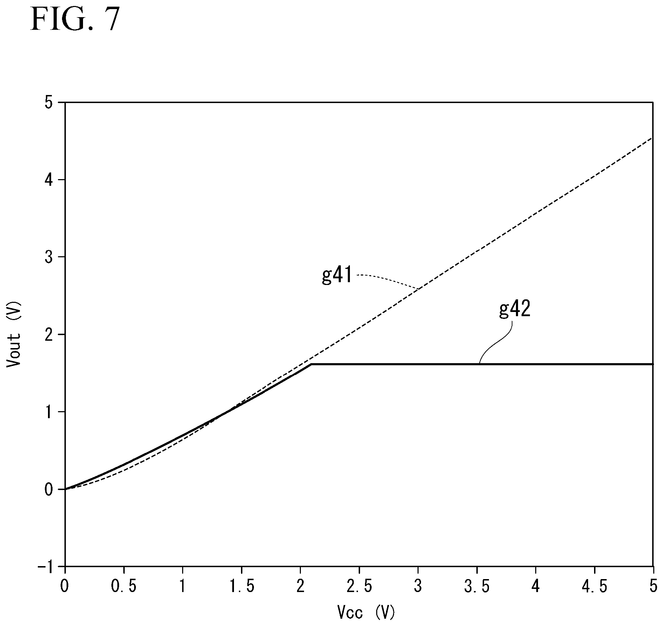

FIG. 7 is a result example of actually measuring the relationship between the power supply voltage Vcc in the electronic circuit and the output voltage output from the output terminal Vout. The horizontal axis represents the power supply voltage Vcc (V), and the vertical axis represents the output voltage (V) output from the output terminal Vout. A line g41 is a measurement result of the capacitor microphone unit ECM not including the conversion circuit 3A, and a line g42 is a measurement result in the case of including the conversion circuit 3A. Note that the measurement conditions are R_{b} of 2.2 kΩ and C_{f} of 1.2 nF. The capacitor microphone used for the measurement has specification characteristics of the sensitivity at 1 kHz being -42.0 ± 2.0 dB, a recommended power supply voltage being 1.5 V, a recommended value of the resistor R_{L} being 1.0 kΩ, a power supply voltage range being 1.0 to 10.0 V, and a frequency characteristic being 50 to 16000 Hz. The variable shunt regulator used in the conversion circuit 3A has specification characteristics of a voltage value to the reference terminal being 1.24 V, output impedance being standard 0.25 Ω, and an output voltage being from the voltage value to the reference terminal up to 18 V. That is, in the present example, the output impedance of the conversion circuit 3A is made 1 Ω or less.

As in FIG. 7, in a case of not using the conversion circuit 3A, as the graph has a slope in any section, the output voltage output from the output terminal Vout fluctuates depending on the power supply voltage Vcc, and therefore the fluctuation of the power supply voltage Vcc becomes noise.

On the other hand, according to the configuration of the present example, in a case of including the conversion circuit 3A, the output voltage output from the output terminal Vout is constant regardless of the power supply voltage Vcc under the condition that the power supply voltage Vcc is 2.1 V or more, and therefore noise does not occur even if the power supply voltage Vcc fluctuates. According to the configuration of the present example, since the output impedance can be lowered, a configuration robust to external noise can be achieved. Then, according to the present example, since noise can be reduced, it is possible to perform recording and reproduction even a signal having a lower level than that in the known technique without being buried in noise.

### (Third Example)

Next, an example in which a transistor having a Darlington connection configuration is used for the conversion circuit will be described.

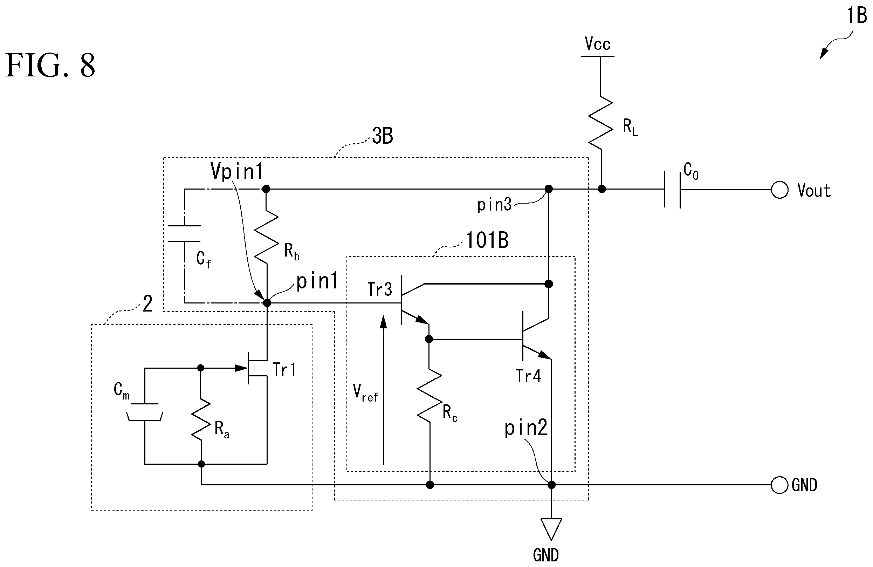

FIG. 8 is a view illustrating a configuration example of the electronic circuit of the third example. As in FIG. 8, an electronic circuit 1B includes the sensor 2 and a conversion circuit 3B.

The sensor 2 is, for example, the capacitor microphone unit ECM. The capacitor microphone unit ECM includes, for example, the capacitor microphone Cₘ, the resistor Rₐ, and the field effect transistor Tr1.

The conversion circuit 3B includes, for example, the capacitor Cr, the resistor R_{b} (first resistor), a transistor Tr3 (first transistor), a transistor Tr4 (second transistor), and a resistor R_{c} (second resistor). Note that the conversion circuit 3B may include the resistor R_{L} (power supply resistor) and the capacitor C_{O}. The conversion circuit 3B need not include the capacitor C_{f} for preventing oscillation. The transistor Tr3 and the transistor Tr4 are NPN type transistors.

A regulator 101B includes, for example, Tr3 (first transistor), the transistor Tr4 (second transistor), and the resistor R_{c} (third resistor).

Next, a connection configuration of the conversion circuit 3B will be described.

The capacitor C_{f} has one end connected to one end of the resistor R_{b}, one end of the resistor R_{L}, one end of the capacitor C_{O}, a collector of the transistor Tr3, and a collector of the transistor Tr4, and has the other end connected to the other end of the resistor R_{b}, a base of the transistor Tr3, and the output of the sensor 2.

The transistor Tr3 has the emitter connected to one end of the resistor R_{c} and a base of the transistor Tr4. The transistor Tr3 and the transistor Tr4 are in Darlington connection.

The other end of the resistor R_{c} is connected to ground.

An emitter of the transistor Tr4 is connected to ground.

The other end of the resistor R_{L} is connected to the power supply voltage Vcc.

The other end of the capacitor Co is connected to the output terminal Vout.

Next, in the conversion circuit 3B, the first terminal, the second terminal, and the third terminal are defined.

In the conversion circuit 3B, an intersection of the output terminal of the sensor 2 (drain of the field effect transistor Tr1), the other end of the resistor R_{b}, the other end of the capacitor C_{f}, and the base of the transistor Tr3 is the first terminal pin1. In this manner, the first terminal pin1 is an input unit of the conversion circuit 3B. Let the voltage at the first terminal pin1 be Vpin1.

Let an intersection of the emitter of the transistor Tr4 and the other end of the resistor R_{c} be the second terminal pin2. Note that the second terminal pin2 is ground.

Let an intersection of one end of the resistor R_{b}, one end of the capacitor C_{f}, the collector of the transistor Tr3, the collector of the transistor Tr4, one end of the resistor R_{L}, and one end of the capacitor C_{O} be the third terminal pin3. In this manner, the third terminal pin3 is a power supply unit as well as an output unit of the conversion circuit 3B.

In the conversion circuit 3B, the gain (R_{b}Is/Is) is determined by the resistor R_{b}. The regulator 101B controls the output voltage. Note that the regulator 101B controls the output voltage using a sink current.

Note that in this configuration, the reference voltage V_{ref} is a voltage between the base of the transistor Tr3 and the second terminal pin2.

In the present example, the regulator 101B detects a difference between the voltage at the first terminal and a predetermined reference voltage, and, when the voltage at the first terminal is higher than the reference voltage, performs control of adjusting the amount of current flowing from the third terminal to the second terminal according to the magnitude of the difference to a possible value within a specification range of the power supply voltage/current, lowering the voltage of the third terminal, and maintaining the voltage at the first terminal at the reference voltage. The current flowing from the third terminal to the second terminal is a sink current (current sink).

Note that when the voltage at the first terminal is lower than the reference voltage or equal to the reference voltage, an operation similar to that in the first example is performed.

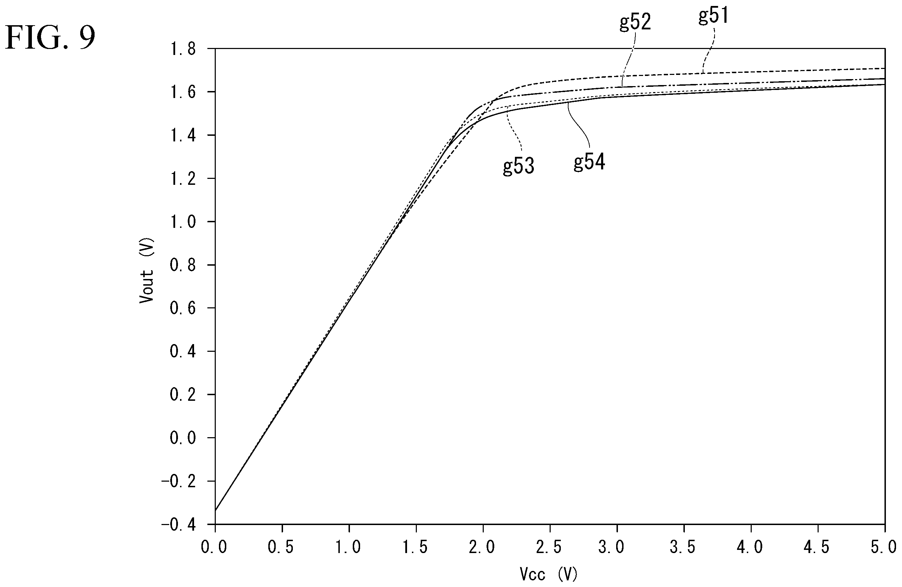

FIG. 9 is a view illustrating a relationship between the power supply voltage Vcc and the output voltage output from an output terminal Vout in the third example. The horizontal axis represents the power supply voltage Vcc (V), and the vertical axis represents the output voltage Vout (V) output from the output terminal Vout. When the sensor 2 is regarded as an equivalent circuit of the current source gₘ and the resistor Rₘₒ (see FIG. 1), the measurement conditions of FIG. 9 are the resistor Rₘₒ of 100 kΩ, the resistor R_{b} of 2.2 kΩ, and the resistor R_{L} of 2.2 kΩ. The resistors R_{c} are 10 kΩ (line g51), 100 kΩ (line g52), 1 MΩ (line g53), and 10 MΩ (line g54). This indicates that the reference voltage can be adjusted by the value of the resistor R_{c}. Note that the current output value of the current source gm is 0.16 mA.

In the configuration of the third example, since the relationship between the power supply voltage Vcc and the output voltage output from the output terminal Vout is as in FIG. 9, at the power supply voltage Vcc of about 2 V or more, the output voltage output from the output terminal Vout becomes substantially constant even if the power supply voltage Vcc changes, and therefore, it is possible to reduce the influence of noise included in the power supply voltage Vcc. Then, according to the present example, since noise can be reduced, it is possible to perform recording and reproduction even a signal having a lower level than that in the known technique without being buried in noise.

### (Fourth Example)

A second example in which a transistor having a Darlington connection configuration is used for the conversion circuit will be described.

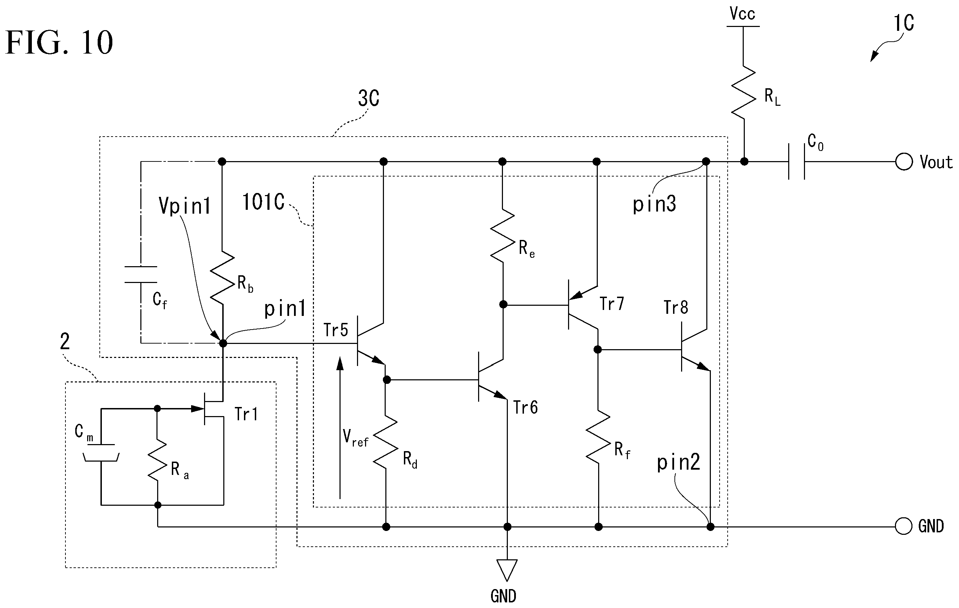

FIG. 10 is a view illustrating a configuration example of the electronic circuit of the fourth example. As in FIG. 10, an electronic circuit 1C includes the sensor 2 and a conversion circuit 3C.

The sensor 2 is, for example, the capacitor microphone unit ECM. The capacitor microphone unit ECM includes, for example, the capacitor microphone Cₘ, the resistor Rₐ, and the field effect transistor Tr1.

The conversion circuit 3C includes, for example, the capacitor C_{f}, the resistor R_{b} (first resistor), a transistor Tr5 (first transistor), a transistor Tr6 (second transistor), a transistor Tr7 (third transistor), a transistor Tr8 (fourth transistor), a resistor R_{d} (second resistor), a resistor Rₑ (third resistor), and a resistor Rr (fourth resistor). Note that the conversion circuit 3C may include the resistor R_{L} (power supply resistor) and the capacitor Co. The conversion circuit 3C need not include the capacitor C_{f} for preventing oscillation. The transistor Tr5, the transistor Tr6, and the transistor Tr8 are NPN type transistors. The transistor Tr7 is a PNP type transistor.

A regulator 101C includes, for example, the transistor Tr5 (first transistor), the transistor Tr6 (second transistor), the transistor Tr7 (third transistor), the transistor Tr8 (fourth transistor), the resistor R_{d} (second resistor), the resistor Rₑ (third resistor), and the resistor R_{f} (fourth resistor).

Next, a connection configuration of the conversion circuit 3C will be described.

The capacitor C_{f} has one end connected to one end of the resistor R_{b}, one end of the resistor R_{L}, one end of the capacitor C_{O}, a collector of the transistor Tr5, one end of the resistor Rₑ, an emitter of the transistor Tr7, and a collector of the transistor Tr8, and has the other end connected to the other end of the resistor R_{b}, a base of the transistor Tr5, and the output of the sensor 2.

The transistor Tr5 has the emitter connected to one end of the resistor R_{d} and a base of the transistor Tr6. The transistor Tr5 and the transistor Tr6 are in Darlington connection.

The other end of the resistor R_{d} is connected to ground.

The transistor Tr6 has a collector connected to the other end of the resistor Rₑ and a base of the transistor Tr7, and has an emitter connected to ground.

The transistor Tr7 has a collector connected to one end of the resistor R_{f} and a base of the transistor Tr8. The transistor Tr7 and the transistor Tr8 are in inverted Darlington connection.

The other end of the resistor R_{f} is connected to ground.

An emitter of the transistor Tr8 is connected to ground.

The other end of the resistor R_{L} is connected to the power supply voltage Vcc.

The other end of the capacitor C_{O} is connected to the output terminal Vout.

Next, in the conversion circuit 3C, the first terminal, the second terminal, and the third terminal are defined.

In the conversion circuit 3C, an intersection of the output terminal of the sensor 2 (drain of the field effect transistor Tr1), the other end of the resistor R_{b}, the other end of the capacitor C_{f}, and the base of the transistor Tr5 is the first terminal pin1. In this manner, the first terminal pin1 is an input unit of the conversion circuit 3C. Let the voltage at the first terminal pin1 be Vpin1.

Let an intersection of the emitter of the transistor Tr8, the other end of the resistor R_{f}, an emitter of the transistor Tr6, and the other end of the resistor R_{d} be the second terminal pin2. Note that the second terminal pin2 is ground.

Let an intersection of one end of the resistor R_{b}, one end of the capacitor C_{f}, the collector of the transistor Tr5, one end of the resistor Rₑ, the emitter of the transistor Tr7, the collector of the transistor Tr8, one end of the resistor R_{L}, and one end of the capacitor C_{O} be the third terminal pin3. In this manner, the third terminal pin3 is a power supply unit as well as an output unit of the conversion circuit 3C.

In the conversion circuit 3C, the gain (R_{b}Is/Is) is determined by the resistor R_{b}. The regulator 101C controls the output voltage. Note that the regulator 101C controls the output voltage using a sink current.

Note that in this configuration, the reference voltage V_{ref} is a voltage between the base of the transistor Tr5 and the second terminal pin2.

The regulator 101C detects a difference between the voltage at the first terminal and a predetermined reference voltage, and, when the voltage at the first terminal is higher than the reference voltage, performs control of adjusting the amount of current flowing from the third terminal to the second terminal according to the magnitude of the difference to a possible value within a specification range of the power supply voltage/current, lowering the voltage of the third terminal, and maintaining the voltage at the first terminal at the reference voltage. The current flowing from the third terminal to the second terminal is a sink current (current sink).

Note that when the voltage at the first terminal is lower than the reference voltage or equal to the reference voltage, an operation similar to that in the first example is performed.

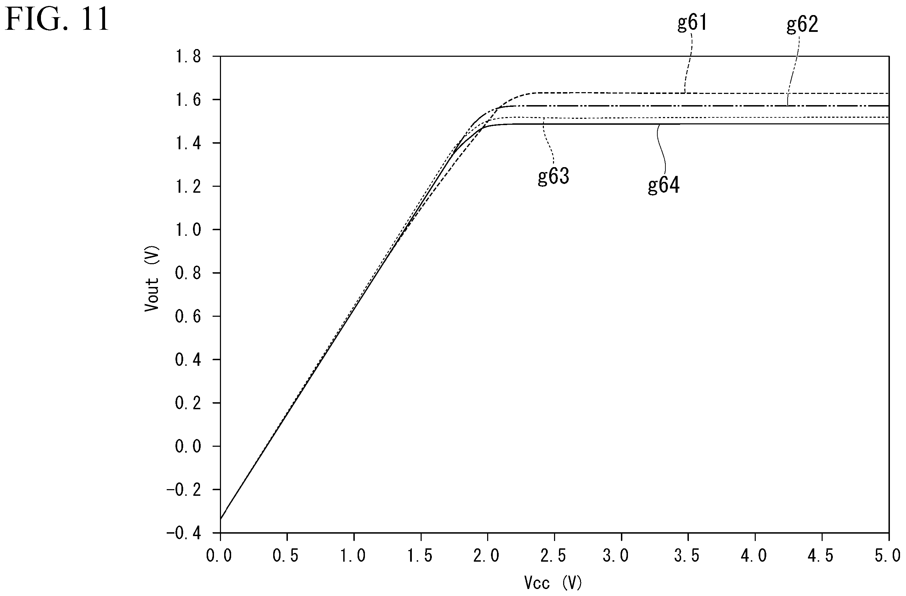

FIG. 11 is a view illustrating a relationship between the power supply voltage Vcc and the output voltage output from an output terminal Vout in the fourth example. The horizontal axis represents the power supply voltage Vcc (V), and the vertical axis represents the output voltage (V) output from the output terminal Vout. When the sensor 2 is regarded as an equivalent circuit of the current source gₘ and the resistor Rₘₒ (see FIG. 1), the measurement conditions of FIG. 11 are the resistor Rₘₒ of 100 kΩ, the resistor R_{b} of 2.2 kΩ, the resistor Rₑ of 10 kΩ, the resistor R_{f} of 5 kΩ, and the resistor R_{L} of 2.2 kΩ. The resistors R_{d} are 10 kΩ (line g61), 100 kΩ (line g62), 1 MΩ (line g63), and 10 MΩ (line g64). This indicates that the reference voltage can be adjusted by the value of the resistor R_{d}. Note that the current output value of the current source gm is 0.16 mA.

In the configuration of the fourth example, since the relationship between the power supply voltage Vcc and the output voltage output from the output terminal Vout is as in FIG. 11, at the power supply voltage Vcc of about 2 V or more, the output voltage output from the output terminal Vout becomes constant even if the power supply voltage Vcc changes, and therefore, it is possible to reduce the influence of noise included in the power supply voltage Vcc. Then, according to the present example, since noise can be reduced, it is possible to perform recording and reproduction even a signal having a lower level than that in the known technique without being buried in noise. In particular, the flat portion in FIG. 11 has a very small inclination as compared with FIG. 9 of the third example, which indicates that the fourth example is particularly excellent in output impedance and external noise resistant performance as compared with the third example.

### (Fifth Example)

A third example in which a transistor having a Darlington connection configuration is used for the conversion circuit will be described.

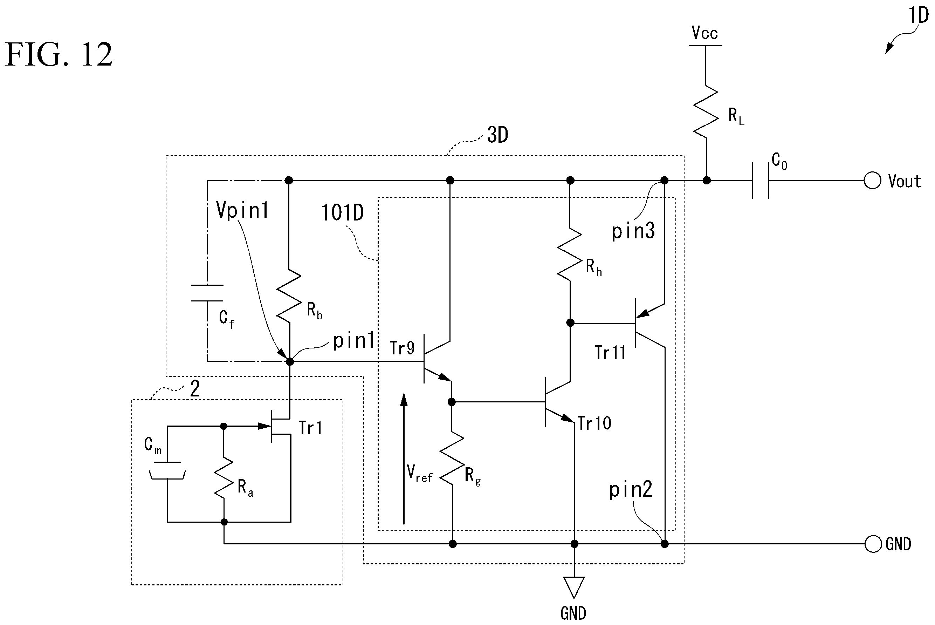

FIG. 12 is a view illustrating a configuration example of the electronic circuit of the fifth example. As in FIG. 12, an electronic circuit 1D includes the sensor 2 and a conversion circuit 3D.

The sensor 2 is, for example, the capacitor microphone unit ECM. The capacitor microphone unit ECM includes, for example, the capacitor microphone Cm, the resistor Rₐ, and the field effect transistor Tr1.

The conversion circuit 3D includes, for example, the capacitor C_{f}, the resistor R_{b} (first resistor), the transistor Tr9 (first transistor), the transistor Tr10 (second transistor), the transistor Tr11 (third transistor), the resistor R_{g} (second resistor), and the resistor Rₕ (third resistor). Note that the conversion circuit 3D may include the resistor R_{L} (power supply resistor) and the capacitor Co. The conversion circuit 3D need not include the capacitor C_{f} for preventing oscillation. The transistor Tr9 and the transistor Tr10 are NPN type transistors. The transistor Tr11 is a PNP type transistor.

A regulator 101D includes, for example, the transistor Tr9 (first transistor), the transistor Tr10 (second transistor), the transistor Tr11 (third transistor), the resistor R_{g} (second resistor), and the resistor Rₕ (third resistor).

Next, a connection configuration of the conversion circuit 3D will be described.

The capacitor C_{f} has one end connected to one end of the resistor R_{b}, one end of the resistor R_{L}, one end of the capacitor C_{O}, a collector of the transistor Tr9, one end of the resistor Rₕ, and an emitter of the transistor Tr11, and has the other end connected to the other end of the resistor R_{b}, a base of the transistor Tr9, and the output of the sensor 2 (drain of the field effect transistor Tr1).

The transistor Tr9 has the emitter connected to one end of the resistor R_{g} and a base of the transistor Tr10. The transistor Tr9 and the transistor Tr10 are in Darlington connection.

The other end of the resistor R_{g} is connected to ground.

The transistor Tr10 has a collector connected to the other end of the resistor Rₕ and a base of the transistor Tr11, and has an emitter connected to ground.

A collector of the transistor Tr11 is connected to ground.

The other end of the resistor R_{L} is connected to the power supply voltage Vcc.

The other end of the capacitor C_{O} is connected to the output terminal Vout.

Next, in the conversion circuit 3D, the first terminal, the second terminal, and the third terminal are defined.

In the conversion circuit 3D, an intersection of the output terminal of the sensor 2 (drain of the field effect transistor Tr1), the other end of the resistor R_{b}, the other end of the capacitor C_{f}, and the base of the transistor Tr9 is the first terminal pin1. In this manner, the first terminal pin1 is an input unit of the conversion circuit 3D. Let the voltage at the first terminal pin1 be Vpin1.

Let an intersection of the collector of the transistor Tr11, an emitter of the transistor Tr10, and the other end of the resistor R_{g} be the second terminal pin2. Note that the second terminal pin2 is ground. Let an intersection of one end of the resistor R_{b}, one end of the capacitor C_{f}, the collector of the transistor Tr9, one end of the resistor Rₕ, the emitter of the transistor Tr11, one end of the resistor R_{L}, and one end of the capacitor Co be the third terminal pin3. In this manner, the third terminal pin3 is a power supply unit as well as an output unit of the conversion circuit 3D.

In the conversion circuit 3D, the gain (R_{b}Is/Is) is determined by the resistor R_{b}. The regulator 101D controls the output voltage. Note that the regulator 101D controls the output voltage using a sink current.

Note that in this configuration, the reference voltage V_{ref} is a voltage between the base of the transistor Tr9 and the second terminal pin2.

The regulator 101D detects a difference between the voltage at the first terminal and a predetermined reference voltage, and, when the voltage at the first terminal is higher than the reference voltage, performs control of adjusting the amount of current flowing from the third terminal to the second terminal according to the magnitude of the difference as long as the power supply voltage/current allows, lowering the voltage of the third terminal, and maintaining the voltage at the first terminal at the reference voltage. The current flowing from the third terminal to the second terminal is a sink current (current sink).

Note that when the voltage at the first terminal is lower than the reference voltage or equal to the reference voltage, an operation similar to that in the first example is performed.

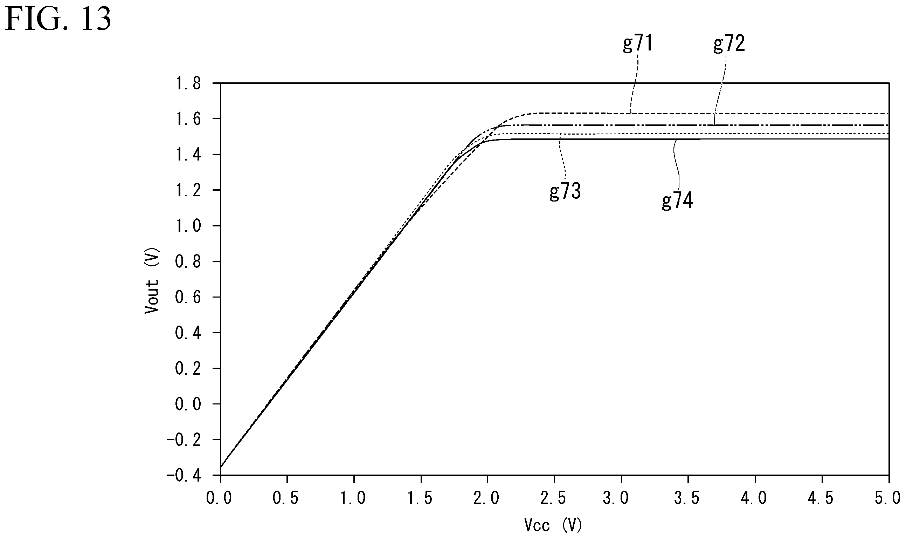

FIG. 13 is a view illustrating a relationship between the power supply voltage Vcc and the output voltage output from an output terminal Vout in the fifth example. The horizontal axis represents the power supply voltage Vcc (V), and the vertical axis represents the output voltage Vout (V) output from the output terminal Vout. When the sensor 2 is regarded as an equivalent circuit of the current source gₘ and the resistor Rₘₒ (see FIG. 1), the measurement conditions of FIG. 13 are the resistor Rₘₒ of 100 kΩ, the resistor R_{b} of 2.2 kΩ, the resistor Rₕ of 10 kΩ, and the resistor R_{L} of 2.2 kΩ. The resistors R_{g} are 10 kΩ (line g71), 100 kΩ (line g72), 1 MΩ (line g73), and 10 MΩ (line g74). This indicates that the reference voltage can be adjusted by the value of the resistor R_{g}. Note that the current output value of the current source gm is 0.16 mA.

In the configuration of the fifth example, since the relationship between the power supply voltage Vcc and the output voltage output from the output terminal Vout is as in FIG. 13, at the power supply voltage Vcc of about 2 V or more, the output voltage output from the output terminal Vout becomes constant even if the power supply voltage Vcc changes, and therefore, it is possible to reduce the influence of noise included in the power supply voltage Vcc. Then, according to the present example, since noise can be reduced, it is possible to perform recording and reproduction even a signal having a lower level than that in the known technique without being buried in noise, and it is possible to balance mountability and external noise resistant performance.

### (Example of Sensor)

Note that in each of the examples described above, an example in which the sensor 2 is a capacitor microphone unit has been described, but no such limitation is intended. The sensor 2 may be, for example, a capacitor microphone alone, or may be a sensor having high output impedance, for example, a pressure sensor, a piezoelectric sensor, a crystal oscillator, an acceleration sensor, an optical sensor, or the like.

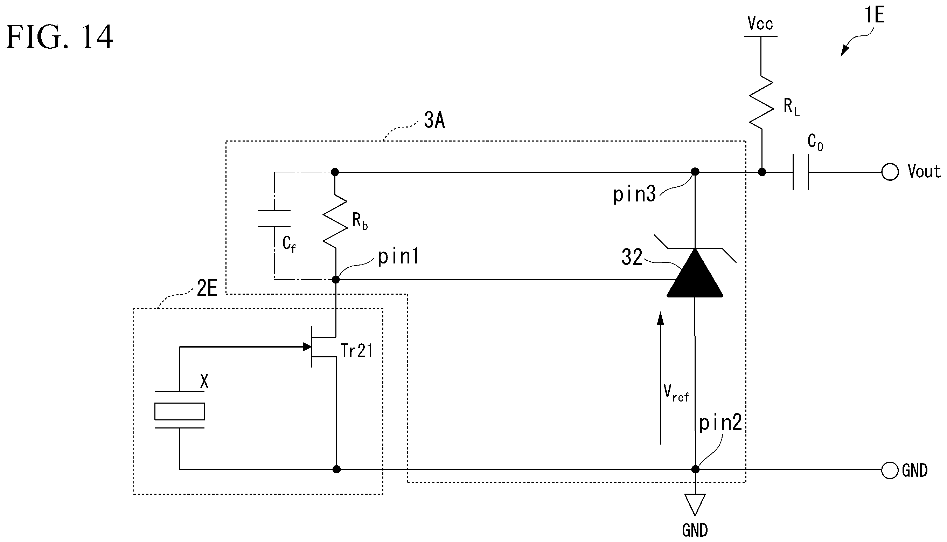

FIG. 14 is a view illustrating a configuration example of an electronic circuit in a case where the sensor is a crystal oscillator.

Since the crystal oscillator generally has high impedance such as several tens of kΩ, noise may be mixed when connected to another circuit. For this reason, as in a sensor 2E in FIG. 14, there is a known configuration of lowering the impedance by combining a crystal oscillator X with a field effect transistor Tr21. In the configuration of the sensor 2E as in FIG. 14, the impedance can be lowered, for example, from 10¹⁴ Ω to about 100 Ω. An electronic circuit 1E in which the above-described conversion circuit 3A is connected to such a sensor 2E can further lower the output impedance, and therefore can further reduce the influence of noise. Note that the conversion circuit may be the conversion circuits 3, 3B, 3C, and 3D described above.

Since crystal has a piezoelectric effect, for example, there is a known configuration in a piezoelectric acceleration sensor, the configuration in which, for example, a capacitor and a resistor are connected in parallel to the crystal oscillator X between the crystal oscillator X and the field effect transistor Tr21 (see, for example, Reference Document 1). Then, by connecting the conversion circuit 3 described above or the like to such a sensor, it is possible to further lower the output impedance, and therefore it is possible to further reduce the influence of noise. Then, according to the present example, since noise can be reduced, it is possible to detect even a signal having a lower level than that in the known technique without being buried in noise.

Reference Document 1; Accelerometer Conversion Types (Piezoelectric Type (PE), Piezoresistive Type (PR), and Capacitive Type (VC) sensors), TOYO Corporation, Feb. 16, 2022, Internet search, Oct 26, 2022 <URL;
https://www.toyo.co.jp/mecha/casestudy/detail/id=34295>

### (Sixth Example)

Next, an example in which a field effect transistor (FET) is used for the conversion circuit will be described.

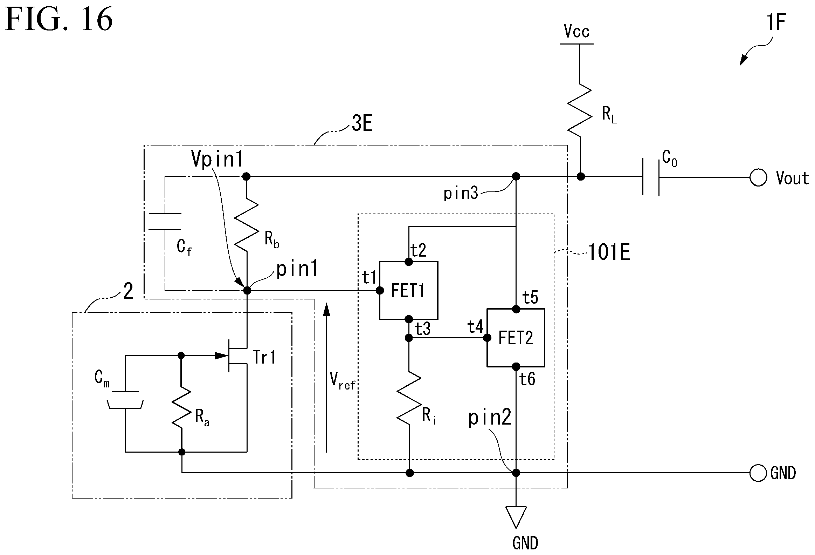

FIG. 16 is a view illustrating a configuration example of the electronic circuit of the sixth example. As in FIG. 16, an electronic circuit 1F includes the sensor 2 and a conversion circuit 3E.

The sensor 2 is, for example, the capacitor microphone unit ECM. The capacitor microphone unit ECM includes, for example, the capacitor microphone Cₘ, the resistor Rₐ, and the field effect transistor Tr1.

The conversion circuit 3E includes, for example, the capacitor C_{f}, the resistor R_{b} (first resistor), a field effect transistor FET1 (first field effect transistor), a field effect transistor FET2 (second field effect transistor), and a resistor Rᵢ (second resistor). Note that the conversion circuit 3E may include the resistor R_{L} (power supply resistor) and the capacitor C_{O}. The conversion circuit 3E need not include the capacitor C_{f} for preventing oscillation. The field effect transistor FET1 and the field effect transistor FET2 are any type of FETs such as a MOSFET, a MESFET, a SiC FET, a GaN FET, and a GaAs FET.

A regulator 101E includes, for example, the field effect transistor FET1 (first field effect transistor), the field effect transistor FET2 (second field effect transistor), and the resistor Rᵢ (second resistor).

Next, a connection configuration of the conversion circuit 3E will be described.

The capacitor C_{f} has one end connected to one end of the resistor R_{b}, one end of the resistor R_{L}, one end of the capacitor Co, a drain terminal t2 of the field effect transistor FET1, and a drain terminal t5 of the field effect transistor FET2, and has the other end connected to the other end of the resistor R_{b}, a gate terminal t1 of the field effect transistor FET1, and the output of the sensor 2.

The field effect transistor FET1 has a source terminal t3 connected to one end of resistor Rᵢ and a gate terminal t4 of the field effect transistor FET2.

The other end of the resistor Rᵢ is connected to ground.

A source terminal t6 of the field effect transistor FET2 is connected to ground.

The other end of the resistor R_{L} is connected to the power supply voltage Vcc.

The other end of the capacitor C_{O} is connected to the output terminal Vout.

Next, in the conversion circuit 3E, the first terminal, the second terminal, and the third terminal are defined.

In the conversion circuit 3E, an intersection of the output terminal of the sensor 2 (drain of the field effect transistor Tr1), the other end of the resistor R_{b}, the other end of the capacitor C_{f}, and the gate terminal t1 of the field effect transistor FET1 is the first terminal pin1. In this manner, the first terminal pin1 is an input unit of the conversion circuit 3E. Let the voltage at the first terminal pin1 be Vpin1.

Let an intersection of the source terminal t6 of the field effect transistor FET2 and the other end of the resistor Rᵢ be the second terminal pin2. Note that the second terminal pin2 is ground.

Let an intersection of one end of the resistor R_{b}, one end of the capacitor C_{f}, the drain terminal t2 of the field effect transistor FET1, the drain terminal t5 of the field effect transistor FET2, one end of the resistor R_{L}, and one end of the capacitor C_{O} be the third terminal pin3. In this manner, the third terminal pin3 is a power supply unit as well as an output unit of the conversion circuit 3E.

In the conversion circuit 3E, the gain (R_{b}Is/Is) is determined by the resistor R_{b}. The regulator 101E controls the output voltage. Note that the regulator 101E controls the output voltage using a sink current.

Note that in this configuration, the reference voltage V_{ref} is a voltage between the gate terminal t1 and the second terminal pin2 of the field effect transistor FET1.

In the present example, the regulator 101E detects a difference between the voltage at the first terminal and a predetermined reference voltage, and, when the voltage at the first terminal is higher than the reference voltage, performs control of adjusting the amount of current flowing from the third terminal to the second terminal according to the magnitude of the difference to a possible value within a specification range of the power supply voltage/current, lowering the voltage of the third terminal, and maintaining the voltage at the first terminal at the reference voltage. The current flowing from the third terminal to the second terminal is a sink current (current sink).

Note that when the voltage at the first terminal is lower than the reference voltage or equal to the reference voltage, an operation similar to that in the first example is performed.

### (Seventh Example)

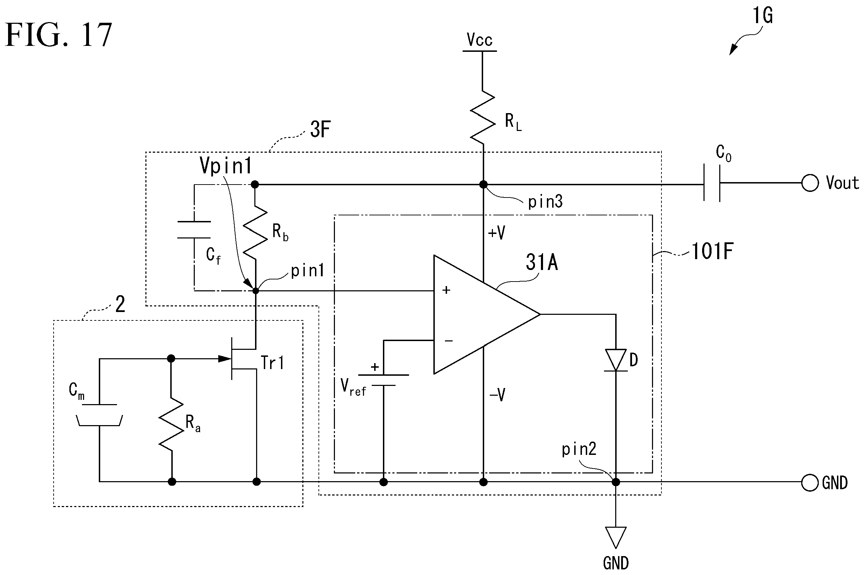

FIG. 17 is a view illustrating an electronic circuit example of the seventh example. As in FIG. 17, an electronic circuit 1G includes the sensor 2 and a conversion circuit 3F.

The sensor 2 is, for example, the capacitor microphone unit ECM. The capacitor microphone unit ECM includes, for example, the capacitor microphone Cₘ, the resistor Rₐ, and the field effect transistor Tr1.

The conversion circuit 3F includes, for example, the capacitor C_{f}, the resistor R_{b} (first resistor), the reference power supply V_{ref}, the operational amplifier 31A, and a diode D. Note that the conversion circuit 3F may include a resistor in place of the diode D. The conversion circuit 3F may include the resistor R_{L} (power supply resistor) and the capacitor Co.

A regulator 101F includes, for example, the operational amplifier 31A, the diode D, and the reference power supply V_{ref}.

Next, a connection configuration of the conversion circuit 3F will be described.

The capacitor C_{f} has one end connected to one end of the resistor R_{b}, one end of the resistor R_{L}, and one end of the capacitor Co, and has the other end connected to the other end of the resistor R_{b}, a positive input terminal (+) of the operational amplifier 31A, and the output of the sensor 2.

The operational amplifier 31A has a negative input terminal (-) connected to the positive electrode of the reference power supply V_{ref}, and has an output terminal connected to an anode of the diode D. Note that the positive power supply terminal +V of the operational amplifier 31A is connected to one end of the resistor R_{L}, the negative power supply terminal -V is connected to ground, and a cathode of the diode D is connected to ground.

A negative electrode of the reference power supply V_{ref} is connected to ground. Note that the reference power supply V_{ref} may be, for example, a Zener diode circuit. In this case, for example, another first resistor not illustrated may have one end connected to one end of the resistor R_{L}, the other first resistor may have the other end connected to a cathode of another first Zener diode not illustrated and the negative input terminal of the operational amplifier 31A, and an anode of the other first Zener diode may be connected to ground.

The other end of the resistor R_{L} is connected to the power supply voltage Vcc.

The other end of the capacitor Co is connected to the output terminal Vout.

Next, in the conversion circuit 3F, the first terminal, the second terminal, and the third terminal are defined.

In the conversion circuit 3F, an intersection of the output terminal of the sensor 2 (drain of the field effect transistor Tr1), the other end of the resistor R_{b}, the other end of the capacitor C_{f}, and the positive input terminal of the operational amplifier 31A is the first terminal pin1. In this manner, the first terminal pin1 is an input unit of the conversion circuit 3F. Let the voltage at the first terminal pin1 be Vpin1.

An intersection of the cathode of the diode D and the negative electrode of the reference power supply V_{ref} is defined as the second terminal pin2. Note that the second terminal pin2 is ground. The negative power supply terminal -V of the operational amplifier 31A is connected to the second terminal pin2.

Let an intersection of one end of the resistor R_{b}, one end of the capacitor Cr, one end of the resistor R_{L}, and one end of the capacitor Co be the third terminal pin3. In this manner, the third terminal pin3 is a power supply unit as well as an output unit of the conversion circuit 3F. The positive power supply terminal +V of the operational amplifier 31A is connected to the third terminal pin3.

In the conversion circuit 3F, the gain (R_{b}Is/Is) is determined by the resistor R_{b}. Note that a current Is is a signal current at the capacitor microphone unit ECM. In the conversion circuit 3F, the operational amplifier 31A is, for example, an operational amplifier, and has a role of an error circuit that detects an error between a signal input to the positive input terminal and a voltage at the reference power supply. The signal current from the capacitor microphone unit ECM is converted into a voltage by the conversion circuit 3F. The regulator 101F controls the output voltage. Note that the regulator 101F controls the output voltage using a sink current.

That is, the regulator 101F detects a difference between the voltage at the first terminal and a predetermined reference voltage, and, when the voltage at the first terminal is higher than the reference voltage, performs control of adjusting the amount of current flowing from the third terminal to the second terminal according to the magnitude of the difference to a possible value within a specification range of the power supply voltage/current, lowering the voltage of the third terminal, and maintaining the voltage at the first terminal at the reference voltage. The current flowing from the third terminal to the second terminal is a sink current (current sink).

On the other hand, when the voltage at the first terminal is lower than the reference voltage, the sink current is adjusted, the voltage of the third terminal is increased to a possible value within a specification range of the power supply voltage/current, and the voltage at the first terminal is maintained at the reference voltage.

When the voltage at the first terminal is equal to the reference voltage, the current amount of the sink current is maintained, and the voltage at the first terminal and the reference voltage are also maintained in an equal state.

In this manner, the voltage Vpin1 at the first terminal is adjusted to be equal to the reference power supply V_{ref} by a feedback circuit described above, and the capacitor microphone unit ECM is applied with a voltage for a sensor.

As described above, the electronic circuit 1 (or 1A, 1B, 1C, 1D, 1F, or 1G) of each of the examples includes the conversion circuit 3 (or 3A, 3B, 3C, 3D, 3E, or 3F), which is a circuit that converts the current output of the sensor 2 (or 2E) into a voltage output and outputs the voltage, and the conversion circuit 3 (or 3A, 3B, 3C, 3D, 3E, or 3F) includes the first terminal pin1, the second terminal pin2, and the third terminal pin3. The electronic circuit 1 (or 1A, 1B, 1C, 1D, 1F, or 1G) of each of the examples includes a power supply circuit unit in which the first terminal pin1 is an input unit and supplies a constant voltage to one of a circuit, an element, and a sensor, and is connected to one of the circuit, the element, and the sensor 2 (or 2E). The second terminal pin2 of the electronic circuit 1 (or 1A, 1B, 1C, 1D, 1F, or 1G) of each of the examples is ground. Furthermore, the third terminal pin3 of the electronic circuit 1 (or 1A, 1B, 1C, 1D, 1F, or 1G) of each of the examples is a power supply unit as well as an output unit of the conversion circuit 3 (or 3A, 3B, 3C, 3D, 3E, or 3F), and the third terminal pin3 is supplied with power from the power supply voltage Vcc to the conversion circuit via the resistor R_{L}.

By this, according to each of the examples as described above, even when noise of the power supply voltage Vcc is superimposed, the influence of the noise can be reduced. Then, according to each of the above examples, since noise can be reduced, it is possible to detect even a signal having a lower level than that in the known technique without being buried in noise. The conversion circuits (3, 3A, 3B, 3C, 3D, 3E, or 3F) can be arranged also in the vicinity of the sensor in which preparation for a stable power supply may be difficult.

Note that although the conversion circuits (3, 3A, 3B, 3C, 3D, 3E, or 3F) described in each of the examples described above appear significantly different at first glance, their equivalent circuits are all the same when extremely simplified, and features described for one conversion circuit (3, 3A, 3B, 3C, 3D, 3E, or 3F) may also apply to other conversion circuits (3, 3A, 3B, 3C, 3D, 3E, or 3F); repeated descriptions are omitted for brevity.

Although an embodiment for carrying out the present invention has been described above using examples, the present invention is not limited to such examples at all, and various modifications and substitutions can be made without departing from the gist of the present invention.

Note that the sixth example corresponds to one in which the field effect transistors (FET1 and FET2) achieve a function to be achieved by the transistors (Tr3 and Tr4) included in the conversion circuit (3B) of the third example. Similarly, the functions to be achieved by the transistors (Tr2, Tr5, Tr6, Tr7, Tr8, Tr9, Tr10, and Tr11) included in the conversion circuits (3, 3C, and 3D) of the first example, the fourth example, and the fifth example, respectively, can be achieved by using the field effect transistor.

### [Reference Signs List]

1, 1A, 1B, 1C, 1D, 1E, 1F, 1G...Electronic circuit, 2, 2E...Sensor, 3, 3A, 3B, 3C, 3D, 3E, 3F...Conversion circuit, C_{f}, C_{O}...Capacitor, D...Diode, Rₐ, R_{b}, R_{c}, R_{d}, Rₑ, R_{f}, R_{g}, Rₕ, Rᵢ, R_{L}...Resistor, Tr1, Tr21...Field effect transistor, Tr2, Tr3, Tr, 4, Tr5, Tr6, Tr7, Tr8, Tr9, Tr10, Tr11...Transistor, FET1, FET2...Field effect transistor, 31, 31A...Operational amplifier, 32...Variable shunt regulator, pin1...First terminal, pin2...Second terminal, pin3...Third terminal, Cₘ...Capacitor microphone, X...Crystal oscillator, V_{ref}...Reference power supply, Vcc...Power supply voltage, Vout...Output terminal/output voltage, 101, 101A, 101B, 101C, 101D, 101E, 101F...Regulator, Vpin1...Voltage at first terminal

## Claims

1. A conversion circuit that converts an input current into an output voltage, the conversion circuit comprising:
a first terminal that is an input unit for the input current;
a second terminal that is ground;
a third terminal that is an output unit for an output voltage, the third terminal being configured to supply a power supply voltage via a power supply resistor;
a first resistor, one end of which is connected to the first terminal and the other end of which is connected to the third terminal; and
a regulator configured to detect a difference between a voltage at the first terminal and a predetermined reference voltage, and, when the voltage at the first terminal is higher than the reference voltage, perform control of adjusting an amount of current flowing from the third terminal to the second terminal according to a magnitude of the difference, and maintaining the voltage at the first terminal at the reference voltage, wherein
a gain of the conversion circuit is determined by the first resistor.

2. The conversion circuit according to claim 1, wherein
the current flowing from the third terminal to the second terminal is a sink current, and wherein the sink current is supplied to the third terminal from an outside of the conversion circuit.

3. The conversion circuit according to claim 1 or 2, wherein:
the regulator comprises a variable shunt regulator;
a reference terminal of the variable shunt regulator is connected to the first terminal;
an anode terminal of the variable shunt regulator is connected to the second terminal; and
a cathode terminal of the variable shunt regulator is connected to the third terminal.

4. The conversion circuit according to claim 1 or 2, wherein:
the regulator includes an operational amplifier and an NPN type first transistor;
a positive input terminal of the operational amplifier is connected to the first terminal;
the reference voltage is input to a negative input terminal of the operational amplifier;
an output terminal of the operational amplifier is connected to a base of the first transistor;
a collector of the first transistor is connected to the third terminal; and
an emitter of the first transistor is connected to the second terminal.

5. The conversion circuit according to claim 1 or 2, wherein:
the regulator includes an NPN type first transistor, an NPN type second transistor, and a second resistor;
a base of the first transistor is connected to the first terminal;
an emitter of the first transistor is connected to the second terminal via the second resistor;
the emitter of the first transistor is connected to a base of the second transistor;
a collector of the first transistor is connected to a collector of the second transistor;
a collector of the second transistor is connected to the third terminal; and
an emitter of the second transistor is connected to the second terminal.

6. The conversion circuit according to claim 1 or 2, wherein:
the regulator includes an NPN type first transistor, an NPN type second transistor, a PNP type third transistor, an NPN type fourth transistor, a second resistor, a third resistor, and a fourth resistor;
a base of the first transistor is connected to the first terminal;
an emitter of the first transistor is connected to the second terminal via the second resistor;
the emitter of the first transistor is connected to a base of the second transistor;
a collector of the first transistor is connected to the third terminal;
an emitter of the second transistor is connected to the second terminal;
a collector of the second transistor is connected to the third terminal via the third resistor;
the collector of the second transistor is connected to a base of the third transistor;
an emitter of the third transistor is connected to the third terminal;
a collector of the third transistor is connected to a base of the fourth transistor;
the collector of the third transistor is connected to the second terminal via the fourth resistor;
a collector of the fourth transistor is connected to the third terminal; and
an emitter of the fourth transistor is connected to the second terminal.

7. The conversion circuit according to claim 1 or 2, wherein:
the regulator includes an NPN type first transistor, an NPN type second transistor, a PNP type third transistor, a second resistor, and a third resistor;
a base of the first transistor is connected to the first terminal;
an emitter of the first transistor is connected to the second terminal via the second resistor;
the emitter of the first transistor is connected to a base of the second transistor;
a collector of the first transistor is connected to the third terminal;
an emitter of the second transistor is connected to the second terminal;
a collector of the second transistor is connected to the third terminal via the third resistor;
the collector of the second transistor is connected to a base of the third transistor;
an emitter of the third transistor is connected to the third terminal; and
a collector of the third transistor is connected to the second terminal.

8. The conversion circuit according to claim 1 or 2, wherein
output impedance of the conversion circuit is 1 Ω or less.

9. The conversion circuit according to claim 1 or 2 comprising:
at least one of: the power supply resistor, one end of which is connected to the third terminal and the other end of which is connected to a power supply voltage; a capacitor, one end of which is connected to the third terminal and the other end of which serves as an output to a load side; or a capacitor, one end of which is connected to the third terminal and the other end of which is connected to the first terminal.

10. The conversion circuit according to claim 1 or 2, wherein:
the regulator includes a first field effect transistor, a second field effect transistor, and a second resistor;
a gate of the first field effect transistor is connected to the first terminal;
a source of the first field effect transistor is connected to the second terminal via the second resistor;
the source of the first field effect transistor is connected to a gate of the second field effect transistor;
a drain of the first field effect transistor is connected to a drain of the second field effect transistor;
a drain of the second field effect transistor is connected to the third terminal; and
a source of the second field effect transistor is connected to the second terminal.

11. The conversion circuit according to claim 1 or 2, wherein:
the regulator includes an operational amplifier and a diode;
a positive input terminal of the operational amplifier is connected to the first terminal;
the reference voltage is input to a negative input terminal of the operational amplifier;
an output terminal of the operational amplifier is connected to an anode of the diode; and
a cathode of the diode is connected to the second terminal.

12. The conversion circuit according to claim 11, wherein:
a positive power supply terminal of the operational amplifier is connected to the third terminal; and
a negative power supply terminal of the operational amplifier is connected to the second terminal.

13. An electronic circuit comprising:
the conversion circuit according to claim 1 or 2; and
a sensor connected to the input unit.

14. The electronic circuit according to claim 13, wherein
the sensor is one of a capacitor microphone, a piezoelectric sensor, a pressure sensor, an acceleration sensor, an optical sensor, and a crystal oscillator.
